Europäisches Patentamt

European Patent Office

Office européen des brevets

(19)

(11) Veröffentlichungsnummer: **0 168 762**
**B1**

(12) # EUROPÄISCHE PATENTSCHRIFT

(45) Veröffentlichungstag der Patentschrift:
**23.11.88**

(51) Int. Cl.⁴: **H 01 L 49/02,** H 03 K 3/42

(21) Anmeldenummer: **85108553.0**

(22) Anmeldetag: **10.07.85**

(54) **Verfahren zur Erzeugung schmalbandiger, zeitlich verzögerter elektrischer Pulse.**

(30) Priorität: **17.07.84 DE 3426196**

(43) Veröffentlichungstag der Anmeldung:
**22.01.86 Patentblatt 86/4**

(45) Bekanntmachung des Hinweises auf die Patenterteilung:
**23.11.88 Patentblatt 88/47**

(84) Benannte Vertragsstaaten:
**BE CH DE FR GB IT LI NL**

(56) Entgegenhaltungen:
**DE-A-1 943 773**
**US-A-4 228 354**

(73) Patentinhaber: **BASF Aktiengesellschaft, Carl-Bosch- Strasse 38, D-6700 Ludwigshafen (DE)**

(72) Erfinder: **Hoffmann, Gerhard, Dr., Pappelstrasse 22, D-6701 Otterstadt (DE)**
Erfinder: **Haarer, Dietrich, Prof. Dr., Hangweg 30, D-8580 Bayreuth (DE)**
Erfinder: **Mueller- Horsche, Elmar Otto, Moltkestrasse 2, D-8580 Bayreuth (DE)**

## Beschreibung

Die Erfindung betrifft ein Verfahren zur Erzeugung schmalbandiger elektrischer Pulse mit zeitlicher Verzögerung gegenüber einem ersten Anfangspuls. Die schmalbandigen, zeitlich verzögerten Pulse werden dabei mittels eines nichtlinearen Schaltelements mit einem Dielektrikum, insbesondere einem Photodielektrikum, erzeugt.

Es sind bereits verschiedene Methoden zur Erzeugung zeitlich verzögerter elektrischer Pulse bekannt. Beispielsweise wird hierzu eine Anordnung aus einer Lichtpulse abgebenden Lichtquelle, einer Photodiode und einem Digitalzähler beschrieben, die nach einer willkürlich einstellbaren Anzahl von Oszillatorpulsen einen verzögerten elektrischen Puls abgibt. Die Realisierung dieser Anordnung erfordert eine Vielzahl von Einzelkomponenten und eine entsprechende elektrische Adaptation. Die Ansteuerung des Digitalzählers mittels eines Spannungspulses ist ebenfalls Stand der Technik und entspricht der Erzeugung elektrischer Pulse mittels Spannungspulsen.

Weiterhin ist die Erzeugung repetitiver elektrischer Pulse bekannt. So werden in A. Barone und G. Paterno, "Physics and Applications of the Josephson-Effect", S. 235-238 und S. 264-290, Verlag John Wiley and Sons (1982) sogenannte "Josephson-Junction-Devices" behandelt, das sind Schaltelemente zur Erzeugung repetitiver elektrischer Pulse ohne Dispersion, d.h. ohne zeitliche Veränderung der Pulsform. Die Verwirklichung solcher Schaltelemente, die z. B. bei der Temperatur des flüssigen Heliums betrieben werden müssen, erfordert einen gewaltigen technischen Aufwand.

Die diversen, aus dem Stand der Technik bekannten elektrischen Anordnungen zur Erzeugung zeitlich verzögerter elektrischer Pulse besitzen nicht nur den Nachteil einer sehr aufwendigen und teilweise sehr komplexen Konstruktion und Betriebsweise, sondern sie sind darüber hinaus auch nur auf eine bestimmte Betriebsart optimiert und für diese verwendbar.

Aufgabe der vorliegenden Erfindung ist es, ein Verfahren zur Erzeugung einfach durchgeführt, universell betrieben und in beliebige elektrische Schaltungen einfach und billig integriert werden kann.

Diese Aufgabe wird erfindungsgemäß in überraschender Weise durch ein Verfahren der in Rede stehenden Art gelöst, bei dem in einem Dielektrikum Raumladungen in einem elektrischen Feld gepulst werden.

Gegenstand der Erfindung ist dementsprechend ein Verfahren zur Erzeugung schmalbandiger, elektrischer Pulse mit zeitlicher Verzögerung gegenüber einem ersten erzeugten Anfangspuls, welches dadurch gekennzeichnet ist, daß in einem Dielektrikum Raumladungen in einem elektrischen Feld gepulst werden.

Gemäß einer bevorzugten Ausführungsform des erfindungsgemäßen Verfahrens wird mit einem Photodielektrikum gearbeitet.

Gemäß einer weiteren besonderen Ausführungsform des erfindungsgemäßen Verfahrens werden in einem Photodielektrikum Raumladungen mittels eines Lichtpulses von Licht aktinischer Wellenlänge gepulst.

Gemäß einer anderen vorzugsweisen Verfahrensvariante werden in einem Photodielektrikum Raumladungen durch einen Spannungspuls gepulst.

Gemäß einer noch weiteren, sehr vorteilhaften Ausgestaltungsform des erfindungsgemäßen Verfahrens werden in einem durch Konstantbelichtung mit aktinischem Licht, insbesondere variabler Intensität, bestrahlten Photodielektrikum Raumladungen durch einen Spannungspuls oder einen Lichtpuls gepulst.

Mit dem erfindungsgemäßen Verfahren können schmalbandige, zeitlich verzögerte elektrische Pulse mit äußerst geringer oder keiner Dispersion erzeugt werden. Unter "Puls" wird dabei im Rahmen dieser Erfindung allgemein jede Stufenfunktion verstanden; es werden hierbei alle Pulsformen umfaßt, beispielsweise ausgehend von einem beliebig schmalen Rechteck bis hin zu einem Rechteck unendlicher Breite. "Pulsen" beinhaltet dementsprechend das gezielte Aufgeben eines Pulses von außen auf ein System. "Schmalbandig" bedeutet, daß die Halbwertsbreite des in dem System erzeugten zeitlich verzögerten elektrischen Pulses (delayed response) sehr klein ist gegenüber seiner Verzögerungszeit. Die zeitliche Verzögerung der erzeugten schmalbandigen Pulse bezieht sich dabei auf einen ersten erzeugten elektrischen, direkten Anfangspuls, d.h. den ersten Antwortpuls des Systems (direct response), der in bekannter Weise unmittelbar nach Anregung des Systems - bei dem erfindungsgemäßen Verfahren unmittelbar nach Pulsen der Raumladungen in dem Dielektrikum unter dem Einfluß eines eingeschalteten elektrischen Feldes - auftritt. Wird z. B. z.Zt. $t_0$ ein Anfangspuls (direct response) induziert, der z.Zt. $t_E$ abgeklungen ist, so wird mit dem erfindungsgemäßen Verfahren z.Zt. $t_P$ ein verzögerter, schmalbandiger elektrischer Puls (delayed response) erzeugt, wobei sich die Verzögerung als Differenz $(t_P-t_0)$ ergibt und erfindungsgemäß, je nach den gewählten Verfahrensbedingungen, verändert werden kann. So können mit dem erfindungsgemäßen Verfahren schmalbandige, zeitlich verzögerte elektrische Pulse erhalten werden, bei denen die Zeit $t_P$ sehr wiel größer als $t_E$ ist; $t_P$ kann aber auch, insbesondere bei der Erzeugung von zeitlich verzögerten repetitiven Pulsen, kleiner sein als $t_E$, d.h. zwischen $t_0$ und $t_E$ liegen.

Zur Durchführung des erfindungsgemäßen Verfahrens können sehr einfache Schaltelemente aus wenigstens einem Dielektrikum, insbesondere einem Photodielektrikum, mit elektrischen Anschlüssen (Elektroden) verwendet werden, wie sie als solche an sich bekannt sind und zum Stand der Technik gehören. Zur Erzeugung der zeitlich verzögerten, schmalbandigen elektrischen Pulse wird erfindungsgemäß, beispielsweise unter Anlegung einer Spannung an die Elektroden, in dem Dielektrikum ein elektrisches Feld erzeugt und werden die in dem Dielektrikum vorhandenen sowie bei Photodielektrika hierin gegebenenfalls durch Bestrahlung mit aktinischem Licht noch erzeugten Raumladungen in geeigneter Weise, beispielsweise elektrisch mittels eines Spannungspulses oder photoelektrisch mittels eines Lichtpulses von Licht aktinischer Wellenlänge, unter Induzierung des Anfangspulses gepulst. Während oder nach Abklingen des Anfangspulses liefert das Schaltelement dann bei weiterhin vorhandenem elektrischen Feld in dem Dielektrikum - je nach Betriebsart - einen oder mehrere zeitlich verzögerte, schmalbandige elektrische Pulse, wobei der zeitliche Abstand zwischen den einzelnen verzögerten Pulsen jeweils groß ist gegenüber der Pulsbreite.

Nachfolgend werden das erfindungsgemäße Verfahren allgemein sowie einzelne verschiedene Betriebsarten dieses Verfahrens anhand der Zeichnungen näher erläutert. Dabei zeigen:

Figur 1: den schematischen Aufbau eines Schaltelementes, wie es zur Durchführung des erfindungsgemäßen Verfahren verwendet werden kann;

Figur 2: die Erzeugung von zeitlich verzögerten, schmalbandigen elektrischen Pulsen in einem Photodielektrikum mittels eines Lichtpulses;

Figur 3: die Erzeugung von zeitlich verzögerten, schmalbandigen elektrischen Pulsen in einem Photodielektrikum mittels eines Spannungspulses;

Figur 4: eine Möglichkeit zur Steuerung der Verzögerungszeit der zeitlich verzögerten, schmalbandigen elektrischen Pulse.

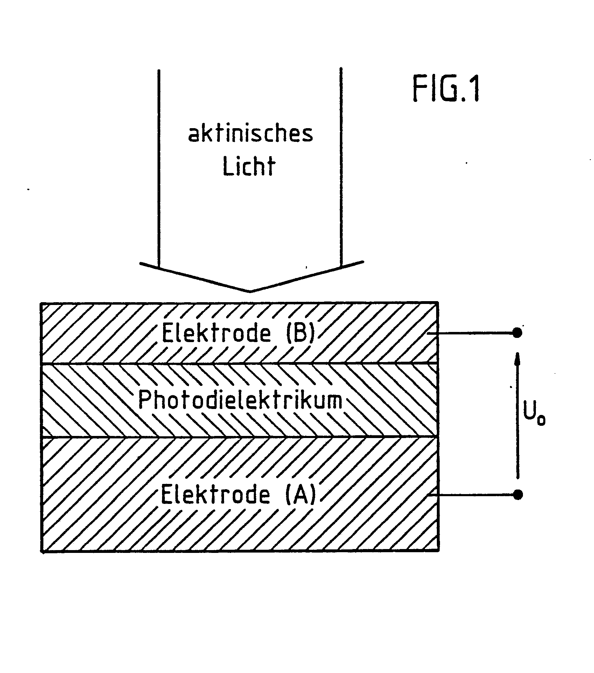

Zur Durchführung des erfindungsgemäßen Verfahrens kann man von einem einfachen Schaltelement ausgehen, wie es beispielsweise in Figur 1 schematisch wiedergegeben ist. Ein solches Schaltelement enthält zwischen zwei Elektroden (A) und (B) und in engem Kontakt mit diesen vorzugsweise ein photodielektrisches Material (C). Die Dicke des Photodielektrikums (C) liegt für die Durchführung des erfindungsgemäßen Verfahrens im allgemeinen im Bereich von 2 bis 100 µm, vorzugsweise im Bereich von 5 bis 25 µm. Die erste, elektrisch gut leitende Elektrode (A) ist vorzugsweise so ausgebildet, daß sie dem Schaltelement gleichzeitig die erforderliche mechanische Stabilität und Dimensionsstabilität verleiht. Diese Elektrode (A) besteht daher vorteilhaft aus einem elektrisch gut leitenden, mechanisch stabilen Material, insbesondere einem metallischen oder metallbeschichteten Träger, wie z. B. Gold, Silber, Aluminiumfolie, Aluminiumblech, goldbedampftem Eisen, metallbedampfter Polyesterfolie, mit einer leitfähigen Indiumoxid/Zinndioxid-Schicht beschichtetem Glas (NESA-Glas), oder beliebigen anderen elektrisch leitfähigen, dimensionsstabilen Materialien. Die zweite Elektrode (B) besteht vorzugsweise aus einem elektrisch gut leitfähigen Material, welches gleichzeitig für Licht im aktinischen Wellenlängenbereich, wie es für die Konstantbelichtung des Photodielektrikums und/oder für die Erzeugung der Lichtpulse eingesetzt wird, durchlässig ist. Sehr geeignet sind hierfür u.a. lichtdurchlässige, z. B. direkt auf das Photodielektrikum (C) aufgedampfte Metallschichten, etwa aus Aluminium, Gold oder ähnlichen Materialien. Meist genügen hierbei für die Elektrode (B) Schichtdicken von etwa 3 bis 50 nm. Sehr vorteilhaft als zweite, lichtdurchlässige Elektrode (B) sind auch die oben erwähnten NESA-Gläser, die nur noch in innigen Kontakt mit dem Photodielektrikum (C) zu bringen sind, wobei die elektrisch leitfähige Oxidbeschichtung der NESA-Gläser in direkten Kontakt zur Oberfläche des Photodielektrikums (C) gebracht wird und nach außen zu einer Spannungsquelle kontaktierbar sein muß. Als lichtdurchlässige Elektrode (B) können auch aluminiumbedampfte Polyesterfolien dienen, sofern sie im aktinischen Wellenlängenbereich hinreichend lichtdurchlässig sind. Die lichtdurchlässige Elektrode (B) kann gemäß einer Ausführungsform der Erfindung auch als Quasielektrode in Form einer mittels einer Corona aufgebrachten Oberflächenladung ausgebildet sein.

Als Photodielektrikum (C), das in dem Schaltelement von Figur 1 zwischen den beiden Elektroden (A) und (B) eingebracht ist und mit diesen in engem Kontakt steht, eignen sich für das erfindungsgemäße Verfahren prinzipiell alle Photodielektrika, wie sie dem Fachmann an sich bekannt und in der Literatur beschrieben sind. Hierzu gehören insbesondere kristalline Photoleiter; amorphe organische Photoleiter; homogen sensibilisierte organische Photoleiter; polymere organische Photoleiter; dispers sensibilisierte, organische Photoleiter; und schichtweise sensibilisierte, organische Photoleiter (z. B. Photoleiter-Doppelschichten), wie sie z. B. zusammenfassend bei W. Wiedemann, Chemiker-Zeitung, 106 (1982), S. 275-287 und S. 313-326 beschrieben sind.

Besonders gute Ergebnisse werden bei dem erfindungsgemäßen Verfahren mit organischen Photodielektrika auf der Basis von Ladungsübertragungs-Komplexen, die zum Typ der polymeren organischen Photoleiter gehören, erhalten. In diese Klasse der Photodielektrika gehören insbesondere die photoleitfähigen Schichten auf Basis von Poly-(N-vinylcarbazol), beispielsweise photoleitfähige Schichten aus 1 Mol Poly-(N-vinylcarbazol) und 0,5 bis 1,5 Molen 2,4,7-Trinitrofluorenon-9, wie sie z. B. in der US-PS-3 484 237 beschrieben sind.

Als Photodielektrikum (C) bevorzugt sind weiterhin auch die Photodielektrika vom schichtweise sensibilisierten Typ, die aus einer ersten Schicht mit bei aktinischer Belichtung Ladungsträger des elektrischen Stromes erzeugenden Pigmenten und/oder Farbstoffen und einer zweiten Schicht mit, vorzugsweise niedermolekularen, Ladungsträger des elektrischen Stromes transportierenden Verbindungen bestehen. Die erste, die Ladungsträger erzeugenden Pigmente und/oder Farbstoffe enthaltende Schicht ist dabei im allgemeinen etwa 0,01 bis etwa 0,4 μm dick und wird entweder nur aus den die Ladungsträger erzeugenden Pigmenten und/oder Farbstoffen gebildet oder enthält diese in einem Bindemittel eingebunden. Die zweite Schicht dieser Photodielektrika vom schichtweise sensibilisierten Typ weist üblicherweise eine Dicke von etwa 2 bis 40 μm auf und wird im allgemeinen gebildet aus einer Mischung von 20 bis 70 Gew.-% mindestens einer, meist niedermolekularen, Ladungsträger transportierenden Verbindung in 30 bis 80 Gew.-% eines polymeren Bindemittels. Diese zweite Schicht mit den Ladungstransportverbindungen kann darüber hinaus gegebenenfalls auch noch bis zu 25 Gew.-%, bezogen auf die Schicht, an weiteren, die mechanischen und/oder elektrischen Eigenschaften der Schicht verbessernden Zusatzstoffen enthalten.

Solche mehrschichtigen Photodielektrika sind als solche bekannt und in der Literatur vielfach, insbesondere im Zusammenhang mit der Herstellung von elektrophotographischen Aufzeichnungsmaterialien mit doppellagigen elektrophotographischen Schichten, beschrieben (vgl. z. B. DE-A-2 220 408). Als Farbstoffe oder Pigmente in den mehrschichtigen Photodielektrika, die bei Bestrahlung mit aktinischem Licht Ladungsträger des elektrischen Stroms erzeugen, eignen sich grundsätzlich alle dem Fachmann bekannten Verbindungen dieser Art, wie z. B. Xanthenfarbstoffe, Triarylmethanfarbstoffe, Isoindoline, Isoindolinone, Perylen-Pigmente, molekular dispers lösliche Perylenfarbstoffe, Azopigmente mit Oxdiazolringen, Rhodamin-Farbstoffe, wie z. B. Rhodamin B, Phthalocyanine und viele andere mehr (vgl. u.a. EP-A-64 946, DE-A-3 110 954, US-PS-4 419 427, US-PS-4 396 695, US-PS-4 389 475, EP-A-61 092). Als Bindemittel für die die Ladungsträger erzeugenden Farbstoffe oder Pigmente enthaltende Schicht der Photodielektrika kommen alle Polymeren mit gutem Filmbildungsvermögen sowie guten mechanischen und elektrischen Eigenschaften in Betracht, die im aktinischen Wellenlängenbereich der Ladungsträger erzeugenden Farbstoffe oder Pigmente optisch nicht absorbieren und die außerdem den Ladungstransport nicht behindern. Beispielhaft erwähnt seien hier: Polyvinylchlorid, Polyester, Polyacetale, Polycarbonate, Polystyrol, Copolymerisate des Styrols mit (Meth)acrylaten und/oder (Meth)acrylsäure und/oder Maleinsäureanhydrid, Cellulosederivate und Silikonharze. Als besonders vorteilhaft haben sich hierbei die Styrolpolymerisate und Vinylchloridpolymerisate erwiesen. Als polymere Bindemittel für die die Ladungsträger transportierenden Verbindungen enthaltende Schicht der mehrschichtigen Photodielektrika eignen sich insbesondere Polycarbonate, aber auch Styrol/Maleinsäureanhydrid- oder Styrol/(Meth)acrylsäure-Copolymerisate, die gegebenenfalls weitere Comonomere, wie z. B. (Meth)acrylate oder geringe Mengen (Meth)acrylsäureanhydrid, einpolymerisiert enthalten können. Als Ladungsträger des elektrischen Stroms transportierende Verbindungen für die Photodielektrika eignen sich die dem Fachmann bekannten Verbindungen dieser Art. Erwähnt seien Oxazolderivate (DE-B-1 120 875), Oxdiazolderivate (DE-B-1 058 836), Triazolderivate (DE-B-1 060 260), Azomethine (US-A-3 041 165), Pyrazolinderivate (DE-B-1 060 714), Imidazolderivate (DE-B-1 106 599) sowie Hydrazonderivate (EP-A-1 599). Als sehr vorteilhaft haben sich hierbei als Ladungstransportverbindungen u.a. die speziellen Hydrazon-Derivate erwiesen, wie sie in der DE-A-3 201 202 beschrieben sind, sowie 2-Phenylbenztriazole-1,2,3 (DE-A-3 215 967 und DE-A-3 215 968), 2-Phenyltriazolopyrimidine (DE-A-3 304 330), 5,6-disubstituierte Benztriazole (DE-A-3 324 641) sowie andere Triazolderivate. Als Zusatzstoffe zur Verbesserung der mechanischen und/oder elektrischen Eigenschaften können den Photodielektrika beispielsweise Weichmacher, wie z. B. Phthalsäureester, Terephthalsäureester und ähnliche; Aktivatoren, wie z. B. Metall-1,3-Diketon-Komplexe oder Metallacetylacetonate; oder weitere oligomere und/oder polymere Hilfsstoffe zugesetzt werden.

Die Elektroden (A) und (B) des in Figur 1 schematisch und beispielhaft dargestellten Schaltelements können mit dem Photodielektrikum (C) auch über Haftschichten verbunden sein. Damit ist es möglich, einen besonders festen und innigen Kontakt zwischen Elektroden und Dielektrikum herzustellen. Diese Haftschichten müssen dabei selbstverständlich für die Ladungsträger des elektrischen Stromes im wesentlichen durchlässig sein und sind dem Fachmann aus der Literatur bekannt.

Zur Durchführung des erfindungsgemäßen Verfahrens unter Einsatz eines Schaltelements gemäß Figur 1 werden in dem zwischen den beiden Elektroden (A) und (B) angeordneten Photodielektrikum (C) die Raumladungen, die immanent vorhanden sind sowie gegebenenfalls auch noch durch Bestrahlung mit aktinischem Licht erzeugt werden, gepulst. Das Pulsen der Raumladungen kann je nach Art der nachfolgend noch näher beschriebenen Verfahrensvarianten in unterschiedlicher Weise, insbesondere aber elektrisch oder photoelektrisch, erfolgen. Auf alle Fälle muß dabei in dem Photodielektrikum (C) ein elektrisches Feld vorhanden sein, welches z. B. in einfacher Weise durch Anlegen einer Gleichspannung an die Elektroden (A) und (B) eingeschaltet und aufgebaut werden kann. Die bei dem erfindungsgemäßen Verfahren zum Einschalten des elektrischen Felds an das Dielektrikum angelegten Spannungen können in weiten Grenzen schwanken und liegen im allgemeinen im Bereich von etwa 10 bis etwa 500 V. Über die Höhe der angelegten Spannung läßt sich unter anderem eine Steuerung der Verzögerung der schmalbandigen, zeitlich verzögerten elektrischen Pulse erzielen. Der Strombedarf liegt in dem Bereich, der für übliche elektrische Schaltelemente bekannt ist. Als Strom- und Spannungsquellen können dabei die üblichen und bekannten Gleichspannungsquellen, wie beispielsweise Batterien und dergleichen, eingesetzt werden. Die Photodielektrika werden gemäß den verschiedenen Ausführungsformen des erfindungsgemäßen Verfahrens auch mit aktinischem Licht in Form eines Lichtpulses und/oder einer konstanten Belichtung beaufschlagt. Unter aktinischem Licht wird hierbei Licht solcher Wellenlänge verstanden, welches für das jeweils eingesetzte Photodielektrikum wirksam ist, d.h. hierin Ladungsträger des elektrischen Stromes zu erzeugen vermag. Für die üblicherweise eingesetzten Photodielektrika kann im allgemeinen aktinisches Licht im Wellenlängenbereich von etwa 200 bis etwa 800 nm verwendet werden. Als Lichtquellen können dabei die üblichen und gebräuchlichen Lichtquellen für aktinisches Licht in diesem Wellenlängenbereich eingesetzt werden. Als Lichtquellen für die Konstantbelichtung der Photodielektrika dienen beispielsweise Leuchtstoffröhren oder Glühlampen, z. B. Wolframlampen, bei denen vorzugsweise die Strahlungsintensität geregelt werden kann. Für die Belichtung der Photodielektrika mit Lichtpulsen werden vorzugsweise Laser, die Laserstrahlen in dem aktinischen Wellenlängenbereich emittieren, eingesetzt. Die Ausgangspulsenergien der Laser liegen typischer Weise im Bereich von etwa 1 $\mu$J bis etwa 100 mJ. Die benötigte Pulsenergie ist je nach Verfahrensvariante unterschiedlich.

Die Erzeugung der schmalbandigen, zeitlich verzögerten elektrischen Pulse läßt sich erfindungsgemäß im Rahmen der oben allgemein angegebenen Verfahrensbedingungen nach verschiedenen Verfahrensvarianten durchführen, die im folgenden näher erläutert werden.

**Verfahrensvariante 1:**

In einem Photodielektrikum mit einem über eine angelegte, konstante Spannung eingeschalteten elektrischen Feld werden mittels eines Lichtpulses schmalbandige, zeitlich verzögerte elektrische Pulse erzeugt.

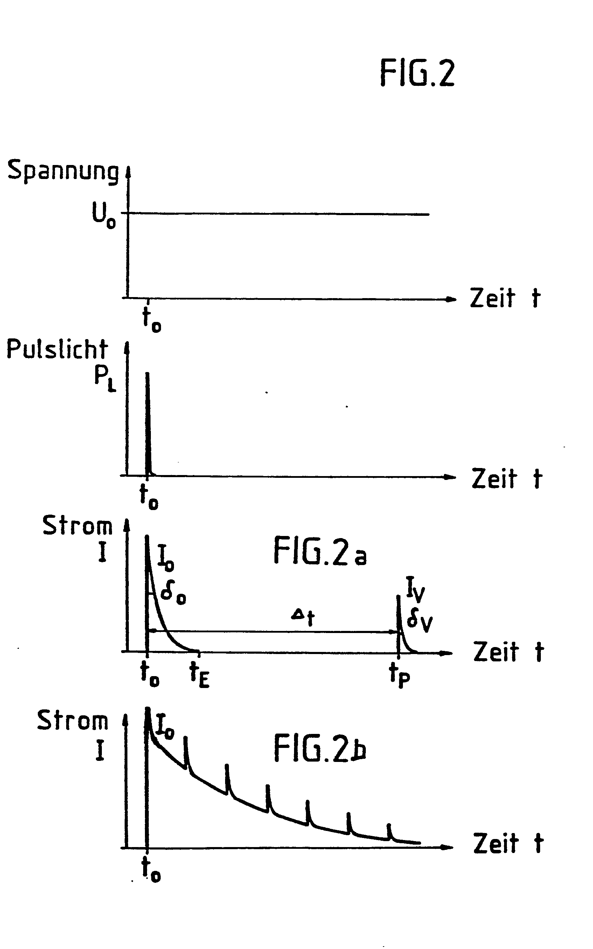

Bei dieser Verfahrensvariante wird ein Schaltelement eingesetzt, wie es beispielsweise in Figur 1 dargestellt ist und welches aus einer dimensionsstabilen Elektrode (A), einer lichtdurchlässigen Elektrode (B) sowie einem zwischen den Elektroden angeordneten Photodielektrikum (C) besteht. An die Elektroden (A) und (B) wird eine über die Zeit konstante Spannung $U_0$, beispielsweise im Bereich von 10 bis 500 V, angelegt und damit in dem Photodielektrikum (C) ein elektrisches Feld aufgebaut. Der Verfahrensablauf ist in Figur 2 im zeitlichen Ablauf wiedergegeben. Nach Anlegen der Spannung $U_0$ wird zur Zeit $t_0$ das Photodielektrikum (C) durch die lichtdurchlässige Elektrode (B) hindurch mit einem Lichtpuls $P_L$ von aktinischem Licht belichtet. Dieser Lichtpuls $P_L$ ist zeitlich sehr kurz mit einer Dauer üblicherweise im Bereich von Nanosekunden und besitzt eine hinreichende Energie, um die in dem Photodielektrikum (C) vorhandenen sowie durch die Bestrahlung mit dem Lichtpuls erzeugten Raumladungen zu pulsen. Die benötigte Mindestpulsenergie hängt u.a. von der Art des Photodielektrikums (C) ab. Üblicherweise wird mit Pulsenergien von gleich oder mehr als etwa 1 $\mu$J.cm$^{-2}$ gearbeitet. In Abhängigkeit von der Energie des eingestrahlten Lichtpulses $P_L$ lassen sich verschiedene Ausführungsformen dieser Verfahrensvariante unterscheiden.

Bei einer Ausführungsform der Verfahrensvariante 1 werden die Raumladungen in dem Photodielektrikum (C) mit einem aktinischen Lichtpuls $P_L$ vergleichsweise niederer Pulsenergie gepulst. Typischerweise wurde hier mit Pulsenergien im Bereich von etwa 1 $\mu$J.cm$^{-2}$ bis etwa 0,1 mJ.cm$^{-2}$ gearbeitet. Wie aus dem zugehörigen Strom/Zeit-Diagramm (Fig. 2a) zu ersehen ist, wird in diesem Fall durch das Pulsen der Raumladungen in dem Photodielektrikum (C) bei eingeschaltetem elektrischen Feld sofort, d.h. z.Zt. $t_0$, ein Strompuls $I_0$ erzeugt. Dieser Strompuls $I_0$ ist der erste erzeugte Anfangspuls, d.h. der direkte Antwortpuls des Systems (direct response), mit der Halbwertszeit $\delta_0$, der zur Zeit $t_E$ auf 0 abgefallen ist. Bei weiter anstehender Spannung $U_0$ an die Elektroden (A) und (B), d.h. bei weiterhin eingeschaltetem elektrischen Feld, gibt das Schaltelement nach einer Zeit $t_P$ einen weiteren, zeitlich verzögerten Strompuls $I_V$ ab. Dieser verzögerte Strompuls $I_V$ ist schmalbandig, d.h. seine Halbwertsbreiter $\delta_V$ ist wesentlich kleiner als die zeitliche Verzögerung $(t_P-t_0)$, also die Differenz zwischen der Zeit, bei der der verzögerte Strompuls $I_V$ auftritt und der Zeit, bei der der Anfangspuls $I_0$ initiiert wurde; sie ist in Figur 2a mit $\Delta t$ gekennzeichnet. Die Halbwertsbreite $\delta_V$ des verzögerten Strompulses $I_V$ ist hierbei häufig kleiner als die Halbwertsbreite $\delta_0$ des Anfangspulses $I_0$; sie kann aber auch in der gleichen Größenordnung liegen. Bei dieser Ausführungsform der Verfahrensvariante 1 ist die Zeit $t_P$, zu der der verzögerte Strompuls $I_V$ auftritt, im allgemeinen

sehr groß gegenüber der Zeit $t_E$, nach der der Anfangspuls $I_0$ abgeklungen ist, d.h. diese Ausführungsform gestattet die Erzeugung eines zeitlich sehr stark verzögerten, schmalbandingen elektrischen Pulses. Während für die Abklingzeit $(t_E-t_0)$ des Anfangspulses $I_0$ beispielsweise weniger als 100 Millisekunden gemessen wurden, lag die zeitliche Verzögerung $\Delta t$ für den verzögerten Puls $I_V$ im Bereich von einigen 100 Millisekunden.

Gemäß einer anderen Ausführungsform der Verfahrensvariante 1 werden die Raumladungen in dem Photodielektrikum (C) mit einem aktischen Lichtpuls $P_L$ vergleichsweise hoher Pulsenergie gepulst, d.h. die Pulsenergie liegt diesmal deutlich höher als im Fall der zuvor beschriebenen Ausführungsform. Im allgemeinen wurde hier mit Pulsenergien von mehr als etwa 0,5 mJ.cm$^{-2}$ gearbeitet, insbesondere mit Pulsenergien im Bereich von etwa 1 bis 10 mJ.cm$^{-2}$. Das Strom/Zeit-Diagramm dieser Ausführungsform der Verfahrensvariante 1 ist in Figur 2b dargestellt. In diesem Fall erscheint, beginnend bei der Zeit $t_0$, eine Serie von äquidistanten Stromspitzen. Diese sitzen auf der abfallenden Flanke des Gesamtstroms und können positives oder negatives Vorzeichen haben. Die erste Stromspitze, die sofort zur Zeit $t_0$ auftritt, ist der Anfangspuls $I_0$, der von einer Vielzahl repetitiver, zeitlich verzögerter Strompulse gefolgt wird, deren Halbwertsbreite wiederum klein gegenüber der Verzögerungszeit ist. Gemäß dieser Ausführungsform der Verfahrensvariante 1 können somit scharfe, schmalbandige, äquidistante, repetitive, zeitlich verzögerte elektrische Pulse erzeugt werden.

**Verfahrensvariante 2:**

In einem gegebenenfalls mit Konstantlicht aktinischer Wellenlänge bestrahlten Photodielektrikum wird durch Einschalten eines elektrischen Feldes mittels eines hierbei erzeugten Spannungspulses ein zeitlich verzögerter, schmalbandiger elektrischer Puls erzeugt.

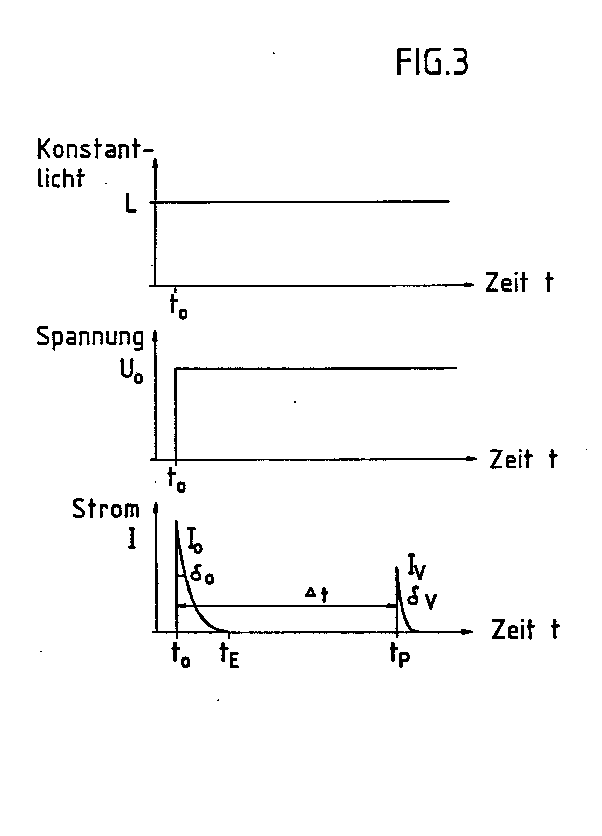

Auch zur Durchführung dieser Verfahrensvariante geht man von einem Photodielektrikum (C) aus, das zwischen einer dimensionsstabilen Elektrode (A) und einer lichtdurchlässigen Elektrode (B) angeordnet ist, wie es in Figur 1 dargestellt ist. Bei der Verfahrensvariante 2 kann das Photodielektrikum (C) durch die lichtdurchlässige Elektrode (B) hindurch konstant mit Licht L aktinischer Wellenlänge bestrahlt werden, wobei die Intensität dieses Konstantlichts L in weiten Grenzen schwanken kann und vorzugsweise variabel ist. Es hat sich gezeigt, daß hierbei im allgemeinen Intensitäten für das eingestrahlte Konstantlicht L bis zu etwa 100 µW.cm$^{-2}$ hinreichend sind. Ein typischer Arbeitsbereich für die Konstantlichtintentsität ist beispielsweise von etwa 10 bis 100 µW.cm$^{-2}$. Es ist jedoch bei dieser Verfahrensvariante gleichermaßen möglich, daß die Intensität des Konstantlichts L gleich Null ist, d.h. daß ohne Konstantbelichtung gearbeitet wird. In Figur 3 ist der zeitliche Ablauf der Verfahrensvariante 2 beispielhaft für die Ausführungsform dargestellt, bei der mit Konstantlicht L einer bestimmten Intensität gearbeitet wird. Man erhält jedoch grundsätzlich die gleichen Ergebnisse, wenn die Intensität des Konstantlichts L variiert wird, einschließlich der Ausführungsform von Verfahrensvariante 2, bei der die Intensität des Konstantlichts L gleich Null ist, d.h. bei der ohne Konstantbelichtung gearbeitet wird. Ob mit oder ohne Konstantbelichtung, wird zu einer Zeit $t_0$ in dem Photodielektrikum (C) ein elektrisches Feld erzeugt, indem an die Elektroden (A) und (B) eine über die Zeit konstante Spannung $U_0$ angelegt wird. Die Spannung $U_0$ liegt typischer Weise in dem weiter oben allgemein angegebenen Bereich von etwa 10 bis 500 V. Durch den beim Einschalten des elektrischen Feldes in dem gegebenenfalls mit dem Konstantlicht L bestrahlten Photodielektrikum (C) auftretenden plötzlichen Spannungssprung (Spannungsstufenfunktion) werden die in dem Photodielektrikum (C) vorhandenen Raumladungen gepulst. Dadurch wird zunächst sofort, d.h. zur Zeit $t_0$, ein Strompuls $I_0$ als erster Antwortpuls des Systems erzeugt. Dieser Anfangspuls $I_0$ hat, wie in Figur 3 dargestellt, eine Halbwertsbreite $\delta_0$ und ist nach der Zeit $t_E$ auf 0 abgeklungen. Während die Spannung $U_0$ weiter an dem Photodielektrikum (C) ansteht, d.h. das elektrische Feld weiterhin eingeschaltet ist, und - falls mit Konstantlicht L bestrahlt wird - das Photodielektrikum (C) auch weiter konstant mit dem aktinischen Licht L beaufschlagt wird, wird nach einer Zeit $t_P$ ein zeitlich verzögerter schmalbandiger elektrischer Puls - in Figur 3 als Strompuls $I_V$ kenntlich gemacht - erzeugt. Die Halbwertsbreite $\delta_V$ des verzögerten Strompulses $I_V$ ist sehr viel kleiner als die Verzögerungszeit $\Delta t$, die sich als Differenz $(t_P-t_0)$ ergibt. Weiterhin ist auch hier die Halbwertsbreite $\delta_V$ des verzögerten Pulses $I_V$ häufig kleiner als, oder in etwa der gleichen Größenordnung wie, die Halbwertsbreite $\delta_0$ des Anfangspulses $I_0$. Ebenfalls ist ferner die Verzogerungszeit $\Delta t$ fur den verzögerten Strompuls $I_V$ groß gegenüber der Abklingzeit $(t_E-t_0)$ des Anfangspulses $I_0$ d.h. man erhält auch hier einen zeitlich stark verzögerten elektrischen Puls. Die Verzögerungszeit $\Delta t$ bei Verfahrensvariante 2 ist dabei abhängig von der Intensität des eingestrahlten Konstantlichts L. $\Delta t$ ist im allgemeinen umso größer, je geringer die Intensität des Konstantlichts L ist. Die stärkste Verzögerung tritt dementsprechend üblicherweise dann auf, wenn ohne Konstantbelichtung garbeitet wird. Durch Variation der Konstantlichtintensität läßt sich somit bei dieser Verfahrensvariante in einfacher Weise die zeitliche Verzögerung der erzeugten elektrischen Pulse steuern.

Die Verfahrensvariante 2 gestattet ebenso wie Verfahrensvariante 1 die Erzeugung schmalbandiger, zeitlich verzögerter elektrischer Pulse, wobei die zeitliche Verzögerung sowie die Stärke dieser Pulse durch die Verfahrensbedingungen, wie z. B. Wahl des Photodielektrikums, angelegte konstante Spannung $U_o$ und Energie des eingestrahlten aktinischen Lichtes, bestimmt und festgelegt werden können.

**Verfahrensvariante 3:**

In einem mit Konstantlicht aktinischer Wellenlänge und variabler Intensität bestrahlten Photodielektrikum, in dem gleichzeitig über eine angelegte, konstante Spannung ein elektrisches Feld eingeschaltet ist, wird mittels eines aktinischen Lichtpulses ein schmalbandiger, zeitlich verzögerter elektrischer Puls erzeugt.

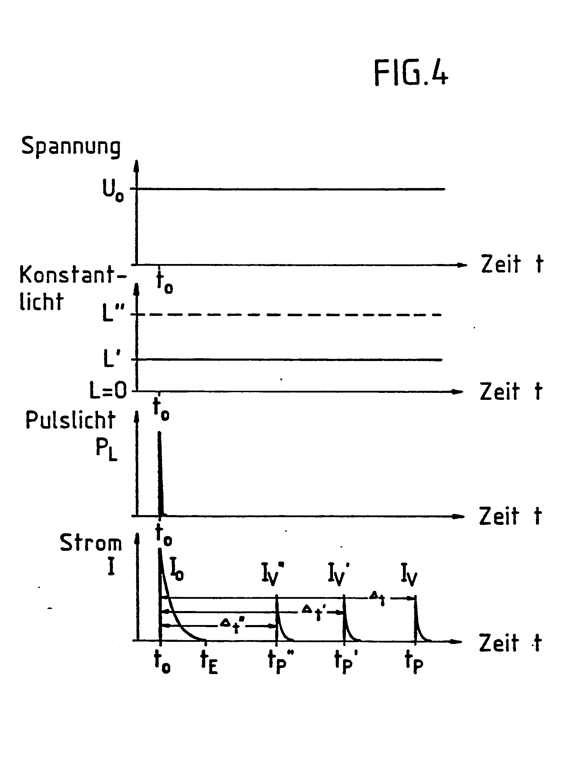

Diese Verfahrensvariante ist eine Abwandlung der Verfahrensvariante 1. Sie bietet die Möglichkeit, gemäß Verfahrensvariante 2 die Verzögerungszeit für das Auftreten des schmalbandigen, zeitlich verzögerten elektrischen Pulses zu variieren und innerhalb bestimmter Grenzen zu steuern, wie in Figur 4 im zeitlichen Diagramm für den Verfahrensablauf dargestellt ist. Ausgehend von einem Schaltelement der in Figur 1 wiedergegebenen Art wird in dem Photodielektrikum (C) zunächst ein elektrisches Feld eingeschaltet, indem an die Elektroden (A) und (B) eine über die Zeit konstante Spannung $U_o$, beispielsweise im Bereich von 10 bis 500 V, angelegt wird. Zusätzlich wird das Photodielektrikum (C) durch die lichtdurchlässige Elektrode (B) hindurch mit konstantem Licht L aktinischer Wellenlänge bestrahlt, wobei die Intensität dieses Konstantlichts L variiert werden kann. Im allgemeinen haben sich hierbei Intensitäten für das eingestrahlte Konstantlicht L bis zu etwa 100 $\mu W.cm^{-2}$ als ausreichend erwiesen. Typischer Weise wurde mit Konstantlichtintensitäten im Bereich von etwa 10 bis 100 $\mu W.cm^{-2}$ gearbeitet. In Figur 4 sind drei verschiedene Betriebszustände dargestellt, wobei einmal die Intensität des Konstantlichtes L gleich 0 beträgt, d.h. ohne Konstantlicht gearbeitet wird, zum zweiten ein Konstantlicht L' niederer Intensität und zum dritten ein Konstantlicht L'' höherer Intensität verwendet wird. Dabei entspricht der erste Betriebszustand, bei dem die Intensität des Konstantlichtes L = 0 ist, bei dem also ohne Bestrahlung mit Konstantlicht L gearbeitet wird, der oben beschriebenen Verfahrensvariante 1. Zusätzlich zum Konstantlicht L wird das Photodielektrikum (C) zur Zeit $t_o$ durch die lichtdurchlässige Elektrode (B) hindurch mit einem Lichtpuls $P_L$, beispielsweise in Form eines Laserschusses, bestrahlt. Dieser Lichtpuls $P_L$ ist sehr kurz mit einer Dauer üblicherweise im Bereich von Nanosekunden. Zur Erzielung eines ausgeprägten Effekts wird hierbei im allgemeinen Pulslicht niederer Intensität eingestrahlt, etwa bis zu 0,1 $mJ.cm^{-2}$, und insbesondere im Bereich von 1 $\mu J.cm^{-2}$ bis 0,1 $mJ.cm^{-2}$. Die eingestrahlte Leistung W des Pulslichtes $P_L$ ist dabei wesentlich größer als die des gleichzeitig eingestrahlten Konstantlichts W (L), so daß für die Lichtleistungen in erster Annäherung gilt W $(P_L)$ + W (L) $\approx$ W $(P_L)$. Durch den Lichtpuls $P_L$ wird sofort zur Zeit $t_o$ ein erster Strompuls, der Anfangspuls $I_o$, erzeugt. Dieser ist nach einer Zeit $t_E$ abgeklungen. Bei weiter anstehender Spannung $U_o$, d.h. bei weiterhin eingeschaltetem elektrischen Feld, und weiterer Bestrahlung mit dem Konstantlicht L wird nun, ähnlich wie bei Verfahrensvarianten 1 und 2, ein gegenüber dem Anfangspuls $I_o$ (Zeit = $t_o$) zeitlich verzögerter Strompuls erzeugt. Die Verzögerungszeit für diesen zeitlich verzögerten Puls, d.h. die Zeitspanne zwischen der Zeit $t_o$ und dem Zeitpunkt, an dem der zeitlich verzögerte Strompuls auftritt, wird entscheidend von der Intensität des eingestrahlten Konstantlichts L beeinflußt. Ist die Intensität des Konstantlichts L gleich 0, so tritt zur Zeit $t_P$ ein verzögerter Strompuls $I_V$ auf (entsprechend Verfahrensvariante 1, Figur 2a). Die Verzögerungszeit $\Delta t$ = $(t_P-t_o)$ ist in diesem Fall am größten. Wird hingegen das Photodielektrikum (C) zusätzlich mit einem Konstantlicht einer bestimmten Intensität bestrahlt, so wird die Verzögerungszeit für den zeitlich verzögerten Strompuls verkleinert, und zwar umso stärker, je höher die Intensität des Konstantlichtes L ist. Wie aus Figur 4 ersichtlich, wird bei einem Konstantlicht L' niedrigerer Intensität zu einer Zeit $t_P$', die kleiner ist als die Zeit $t_P$ ein verzögerter Strompuls $I_V$' erzeugt. Die Verzögerungszeit $\Delta t$' für diesen verzögerten Strompuls $I_V$' ist kleiner als die Verzögerungszeit $\Delta t$ für den verzögerten Strompuls $I_V$, der ohne Konstantbelichtung erzeugt wird. Wird eine Belichtung mit Konstantlicht L'' höherer Intensität gewählt, so verschiebt sich der zugehörige verzögerte Strompuls $I_V$'' zu einer noch kürzeren Zeit $t_P$'' hin. Wie bei den Verfahrensvarianten 1 und 2 sind auch hier die erzeugten, zeitlich verzögerten elektrischen Pulse schmalbandig, d.h. ihre Halbwertszeit ist klein im Vergleich zu ihrer Verzögerungszeit. Ebenfalls ist die Verzögerungszeit groß gegenüber der Abklingzeit $(t_E-t_o)$ des Anfangspulses $I_o$ und ist die Halbwertsbreite des zeitlich verzögerten Pulses häufig kleiner oder auch in der gleichen Größenordnung wie die des Anfangspulses $I_o$. Die Variation der Intensität des Konstantlichtes L hat dabei keinen, zumindest keinen nennenswerten Einfluß auf die Intensität, die Halbwertsbreite und die Schmalbandigkeit des zeitlich verzögerten Strompulses $I_V$, sondern allein auf den Zeitpunkt $t_P$, zu dem dieser zeitlich verzögerte Stompuls $I_V$ auftritt. Bei Verfahrensvariante 3 handelt es sich somit um eine eindeutige Verzögerungssteuerung für die Erzeugung schmalbandiger, verzögerter elektrischer Pulse.

Die Ausführung des erfindungsgemäßen Verfahrens ist nicht auf die vorstehend beschriebenen, besonders bedeutungsvollen und technisch wichtigen Verfahrensvarianten beschränkt, sondern kann selbstverständlich in weitem Umfang variiert werden. So sind weitere Verfahrensvarianten oder Modifikationen der beschriebenen Verfahrensvarianten gleichermaßen denkbar und möglich wie Varianten in Art und Aufbau des Schaltelements. Beispielsweise ist es möglich, anstelle des Photodielektrikums ein anderes Dielektrikum mit immanenten Raumladungen zu verwenden, wie beispielsweise eine Polyesterfolie, und das Pulsen der Raumladungen entsprechend Verfahrensvariante 2 mittels eines Spannungspulses vorzunehmen. Des weiteren muß beispielsweise die an das Schaltelement angelegte Spannung $U_0$ über die Zeit nicht unbedingt konstant sein, sondern kann beispielsweise zu- oder auch abnehmen. Eine weitere interessante Abwandlung der oben beschriebenen Verfahrensvarianten 1 und 3 besteht darin, daß das Schaltelement nur aus der Elektrode (A) und dem Photodielektrikum (C) besteht und die Elektrode (B) durch eine Quasielektrode in Form einer mittels einer Corona aufgebrachten Oberflächenladung ersetzt wird. Da sich in diesem Fall bereits durch das Aufsprühen der Oberflächenladung in dem Dielektrikum ein elektrisches Feld ausbildet, entfällt in diesen Fällen das Anlegen einer äußeren Spannung $U_0$, d.h. nach Aufsprühen der Oberflächenladung mittels einer Corona wird das Photodielektrikum in der bei den angesprochenen Verfahrensvarianten genannten Art mit Pulslicht sowie gegebenenfalls zusätzlich auch noch Konstantlicht bestrahlt. Weitere denkbare Abwandlungen und Ausgestaltungsformen ergeben sich für den Fachmann aufgrund der gemachten Ausführungen und werden ebenfalls durch das erfindungsgemäße Verfahren mitumfaßt, auch wenn sie nicht im einzelnen angeführt sind.

Mit dem erfindungsgemäßen Verfahren ist es möglich, schmalbandige, gegenüber einem Anfangspuls zeitlich verzögerte elektrische Pulse in sehr einfacher, exakt reproduzierbarer Weise zu erzeugen. Die in diesem Verfahren einzusetzenden Schaltelemente zeigen einen sehr einfachen Aufbau, sind billig herzustellen, sowohl in der Handhabung als auch hinsichtlich des Betriebes unanfällig sowie in einfacher Weise zu betreiben und lassen sich problemlos in beliebige Schaltkreise integrieren. Anwendungsbereiche des erfindungsgemäßen Verfahrens sind beispielsweise optischelektronische Schaltungen im Bereich der Analog- und Digitalschaltungen sowie der optischen Informationsverarbeitung.

Die Erfindung wird durch die nachfolgenden Beispiele weiter erläutert.

## Beispiel 1

Es wurde eine Lösung I hergestellt aus 2,5 g eines Polycaprolactams (Schmelztemperatur 220°C) und 5,0 g Rhodamin B (C.I. 45 170) in 1000 g eines Lösungsmittelgemisches aus 60 Volumenprozent Wasser und 40 Volumenprozent Methanol. Mit dieser Lösung I wurde ein feingebürstetes Aluminiumblech (Dicke 0,3 mm) in einer solchen Dicke beschichtet, daß nach dem Ablüften des Lösungsmittels und Trocknen (30 Minuten bei 95°C) ein Film von 0,15 µm Dicke auf dem Aluminium resultierte (Ladungsträger des elektrischen Stromes erzeugende Schicht = Schicht I).

Auf diese Schicht I wurde eine Lösung II in gleichmäßiger Schichtdicke aufgetragen, die in 900 g Tetrahydrofuran 60 g eines Styrol/Acrylsäure-Copolymerisats (80 Gew.-% Styrol, 20 Gew.-% Acrylsäure; mittleres Molekulargewicht - Zahlenmittel: 2800) und 40 g 2-(4-Diethylaminophenyl)-benztriazol-1,2,3 enthielt. Nach dem Ablüften des Lösungsmittels und Trocknen (30 Minuten bei 70°C) resultierte eine Schicht einer Schichtdicke von 4,5 µm (Ladungsträger des elektrischen Stromes transportierende Schicht = Schicht II).

Auf diese Schicht II wurde anschließend im Hochvakuum eine noch lichtdurchlässige, sehr dünne Schicht aus Gold aufgedampft. Es resultierte ein Schaltelement mit einer ersten Elektrode aus Aluminium, einer zweiten, lichtdurchlässigen Elektrode aus Gold sowie einem zwischen diesen beiden Elektroden angeordneten zweischichtigen Photodielektrikum.

An die Elektroden dieses Schaltelements wurde mittels einer Gleichspannungsquelle eine Spannung $U_0$ von 300 Volt angelegt. Anschließend wurde das Photodielektrikum (Schicht I + Schicht II) durch die Goldelektrode hindurch mit einem Laser-Puls einer Wellenlänge von 580 nm belichtet. Die Energie des Laser-Pulses betrug 85 µJ.cm$^{-2}$; die Dauer des Laser-Pulses betrug 10 Nanosekunden. Sofort beim Einstrahlen des Laser-Pulses (Zeit = $t_0$) wurde ein erster Strompuls (Anfangspuls $I_0$) von etwa 0,3 µA gemessen; dieser erste Stromstoß $I_0$ war nach etwa 50 Millisekunden wieder auf 0 abgeklungen. Nach etwa 320 Millisekunden, gerechnet vom Zeitpunkt $t_0$ an, wurde ein scharfer, verzögerter Strompuls $I_V$ von etwa 0,08 µA gemessen. Der verzögerte Strompuls $I_V$ war sehr schmalbandig, er war nach etwa 20 Millisekunden auf 0 abgeklungen. Verlauf und Aussehen des Anfangspulses $I_0$ und des zeitlich verzögerten Pulses $I_V$ entsprachen Figur 2a.

## Beispiel 2

Auf eine 80 µm dicke Polyesterfolie mit einer einseitigen Aluminiumbedampfung von 30 nm Dicke wurde eine 0,08 µm dicke Sperrschicht aus einem Polyamid (Schmelztemperatur 255°C) aufgebracht. Auf diese Sperrschicht wurde eine Lösung aus 26,64 Gewichtsteilen Poly-(N-vinylcarbazol), 31,5 Gewichtsteilen 2,4,7-Trinitrofluorenon-9 und 2,3 Gewichtsteilen Dimethylterephthalat in 544 Gewichtsteilen Tetrahydrofuran in einer solchen Naßschichtdicke aufgetragen, daß nach Abdampfen des Lösungsmittels und Trocknung (90 Minuten bei 85°C) eine Trockenschichtdicke von µm resultierte. Auf die so hergestellte photodielektrische Schicht wurde anschließend noch eine lichtdurchlässige Aluminiumschicht aufgedampft.

Die beiden Aluminiumschichten des so erhaltenen Schaltelementes wurden kontaktiert und an eine Gleichstromquelle mit einer Spannung von 400 V angeschlossen. Anschließend wurde die photodielektrische Schicht durch die lichtdurchlässige Aluminiumschicht hindurch mit einem Laser-Puls einer Wellenlänge von 308 nm bestrahlt. Der Laser-Puls mit einer Dauer von 10 Nanosekunden hatte eine Energie von 1 mJ.cm$^{-2}$. Nach einem ersten Strompuls $I_o$, der sofort bei Einstrahlung des Laser-Pulses auftrat, wurden 12 repetitive, verzögerte Strompulse gemessen, die auf der abklingenden Planke des Gesamtstromes aufsaßen. Die repetitiven, verzögerten Strompulse waren schmalbandig und äquidistant mit einem Abstand von etwa 0,65 Microsekunden. Das aufgezeichnete Strom/Zeit-Diagramm entsprach dem in Figur 2b wiedergegebenen schematischen Bild, wobei die repetitiven verzögerten Pulse jedoch im Vergleich zum Anfangspuls $I_o$ ein umgekehrtes Vorzeichen besaßen.

**Patentansprüche**

1. Verfahren zur Erzeugung von schmalbandigen elektrischen Pulsen mit einer zeitlichen Verzögerung gegenüber einem ersten erzeugten, direkten Anfangspuls, dadurch gekennzeichnet, daß in einem Dielektrikum Raumladungen in einem elektrischen Feld gepulst werden.

2. Verfahren nach Anspruch 1, dadurch gekennzeichnet, daß ein Photodielektrikum eingesetzt wird.

3. Verfahren nach Anspruch 1 und 2, dadurch gekennzeichnet, daß die Raumladungen durch Bestrahlen mit aktinischem Licht gepulst werden.

4. Verfahren nach einem der Ansprüche 1 bis 2, dadurch gekennzeichnet, daß die Raumladungen elektrisch gepulst werden.

5. Verfahren nach einem der Ansprüche 1 bis 4, dadurch gekennzeichnet, daß in einem Photodielektrikum, das mit Konstantlicht aktinischer Wellenlänge bestrahlt wird, Raumladungen bei eingeschaltetem elektrischen Feld mittels eines Spannungs- oder eines Lichtpulses gepulst werden.

6. Verfahren nach einem der Ansprüche 1 bis 5, dadurch gekennzeichnet, daß ein Dielektrikum auf Basis eines polymeren organischen Photoleiters verwendet wird.

7. Verfahren nach einem der Ansprüche 1 bis 5, dadurch gekennzeichnet, daß als Dielektrikum ein zweischichtiges Photodielektrikum mit einer Ladungsträger des elektrischen Stroms erzeugenden Schicht und einer die Ladungsträger des elektrischen Stroms transportierenden Schicht verwendet wird.

**Claims**

1. A method for generating narrow-band electrical pulses which are delayed with respect to a first direct pulse generated, wherein space charges are pulsed in an electric field in a dielectric.

2. A method as claimed in claim 1, wherein a photodielectric is employed.

3. A method as claimed in claims 1 and 2, wherein the space charges are pulsed by exposure to actinic light.

4. A method as claimed in either of claims 1 and 2 wherein the space charges are pulsed electrically.

5. A method as claimed in one of claims 1 to 4, wherein space charges are pulsed by means of a voltage or light pulse in the presence of an electric field in a photodielectric which is exposed to constant light of actinic wavelength.

6. A method as claimed in one of claims 1 to 5, wherein a dielectric based on a polymeric organic photoconductor is used.

7. A method as claimed in one of claims 1 to 5, wherein a two-layer photodielectric which has a charge carrier-producing layer and a charge carrier-transporting layer is used as dielectric.

**Revendications**

1. Procédé de production d'impulsions electriques à bande étroite avec un retard par rapport à une première impulsion initiale directe produite, caractérisé par le fait que dans un diélectrique on pulse des charges d'espace dans un champ électrique.

2. Procédé selon la revendication 1, caractérisé par le fait qu'on utilise un photodiélectrique.

3. Procédé selon la revendication 1 ou 2, caractérisé par le fait qu'on pulse les charges d'espace par irradiation avec de la lumière actinique.

4. Procédé selon l'une des revendications 1 et 2, caractérisé par le fait qu'on pulse les charges d'espace électriquement.

5. Procédé selon l'une des revendications 1 à 4, caractérisé par le fait que, dans un photodiélectrique qu'on irradie avec de la lumière constante de longueur d'onde actinique, le champ électrique étant établi, on pulse des charges d'espace au moyen d'une impulsion de tension de lumière.

6. Procédé selon l'une des revendications 1 à 5, caractérisé par le fait qu'on utilise un diélectrique à base d'un photoconducteur organique polymère.

7. Procédé selon l'une des revendications 1 à 5, caractérisé par le fait qu'on utilise comme diélectrique un photodiélectrique à deux couches, avec une couche qui produit des porteurs de charge du courant électrique et une couche qui transporte les porteurs de charge du courant électrique.

FIG.1

aktinisches
Licht

Elektrode (B)

Photodielektrikum

Elektrode (A)

$U_0$

# FIG.2

Spannung, $U_0$ / Zeit $t$ / $t_0$

Pulslicht, $P_L$ / Zeit $t$ / $t_0$

## FIG.2a

Strom $I$ / $I_0$ / $\delta_0$ / $\Delta t$ / $I_V$ / $\delta_V$ / Zeit $t$ / $t_0$ / $t_E$ / $t_P$

## FIG.2b

Strom $I$ / $I_0$ / Zeit $t$ / $t_0$

# FIG.3

Konstantlicht

$L$ ———————————————

$t_0$  → Zeit $t$

Spannung
$U_0$ ———————————————

$t_0$  → Zeit $t$

Strom
$I$

$I_0$
$\delta_0$
$\Delta t$
$I_V$
$\delta_V$

$t_0$  $t_E$  $t_P$  → Zeit $t$

# FIG.4